# EUROPEAN PATENT SPECIFICATION

(11) **EP 3 297 785 B1**
(45) Date of publication and mention of the grant of the patent: **08.04.2020**
(21) Application number: 16727023.0
(22) Date of filing: 13.05.2016
(51) Int. Cl.: B23K 1/008, B23K 3/04, B23K 3/08, C09D 133/00, F27B 9/30, F27B 9/34, F27D 1/10, F27D 1/16

(54) **REFLOW OVEN LINER WITH A SUBSTRATE AND AN ADHESIVE LAYER, AND A METHOD OF TREATING THE SURFACE OF A REFLOW OVEN**
AUSKLEIDUNG EINES REFLOW-OFENS MIT EINEM SUBSTRAT UND EINER HAFTSCHICHT UND VERFAHREN ZUR OBERFLÄCHENBEHANDLUNG EINES REFLOW-OFENS
REVÊTEMENT DE FOUR À REFUSION COMPRENANT UN SUBSTRAT ET UNE COUCHE ADHÉSIVE, ET PROCÉDÉ DE TRAITEMENT DE LA SURFACE D'UN FOUR À REFUSION

(30) Priority: 21.05.2015 US 201562164855 P; 12.05.2016 US 201615153349
(43) Date of publication of application: 28.03.2018
(73) Proprietor: Illinois Tool Works Inc., Glenview, IL 60025 (US)
(72) Inventor: BLAIR, Paul M., Glenview, IL 60025 (US); BAILEY, Elizabeth B., Glenview, IL 60025 (US)
(74) Representative: Trinks, Ole
(86) International application number: PCT/US2016/032369
(87) International publication number: WO 2016/187010

(56) References cited:
- US-A1- 2013 256 389
- US-A1- 2014 209 662
- US-B1- 6 238 249
- US-B1- 8 840 984
- US-B2- 8 940 099

## Description

The present invention relates to a liner for contamination control in a reflow oven and a method of treating the surfaces of a reflow oven according to the preamble of claims 1 and 7 (see, for example, US 2013/256389 A1).

### BACKGROUND

Electronic components are often surface mounted onto a printed circuit board using a reflow process. Such a process is carried out in a reflow soldering oven that is designed to heat the printed circuit board during the reflow process.

In the fabrication of printed circuit boards, electronic components are often surface mounted to a bare board by a process known as "reflow soldering." In a known reflow soldering process, a pattern of solder paste is deposited onto the circuit board and the leads of one or more electronic component are inserted into the deposited solder paste. The circuit board is then passed through an oven where the solder paste is reflowed (i.e., heated to a melt or reflow temperature) in the heated zones of the oven and then cooled in a cooling zone of the oven to electrically and mechanically connect the component leads to the circuit board. For purposes of the present disclosure the term "circuit board" or "printed circuit board" includes any type of substrate assembly of electronic components, including, for example, wafer substrates.

Known reflow ovens have a heating chamber or zone and a cooling chamber or zone. Soldering flux, which is a component of solder paste, facilitates proper flow of the solder paste. In the heating and cooling zones, some portions of the flux and flux decomposition products vaporize. Possible subsequent flux condensation on cooler surfaces on the ovens requires extraction and collection of the flux vapors away from the heating and cooling chambers to maintain consistent processing. To achieve flux removal, two types of reflow ovens--air reflow ovens and inert atmosphere reflow ovens are used. In air reflow ovens, flux is extracted by an exhaust system. In inert atmosphere reflow ovens, a flux management system is used to extract flux from the heating/cooling chambers.

Contaminant buildup occurs at various locations in the reflow oven. For example, at the oven entrance, the buildup of adipic acid with little amine may occur. In the cooling zone, resin/rosin decomposition products may be seen.

Both flux removal systems suffer from well-known shortcomings. With both systems, flux continues to deposit onto the bottom or floor and inner walls of the heating/cooling chambers. Over time, the flux collected on the chamber floor and walls creates problems during production as excess flux may drip back onto actual production printed circuit boards, which can potentially contaminate or otherwise compromise the attachment of components onto the printed circuit boards.

Under current production requirements, it is desired to continuously operate fabrication equipment, including reflow ovens. As such, when contemplating scheduled maintenance of the fabrication equipment, it is also desirable to keep down-time as short as possible. During scheduled maintenance, the removal of flux on chamber walls is generally not addressed. Thus, there may be an ongoing and exaggerated flux contamination exposure of the printed circuit boards being produced. Over time, excess flux may also cause premature failures of components of the reflow oven, including blowers designed to facilitate air circulation within the reflow oven chamber.

Ngai, US 8,940, 099 discloses a reflow oven that has a chamber housing including surfaces that are in contact with heated air mixed with contaminants, including flux, which surface are coated with a water-soluble layer selectively applied to the surfaces of the chamber housing, and a method of treating the surfaces of a reflow oven. The oven surfaces are coated with an acrylic-based layer, such as an acrylic paint.

While such a coating functions well to facilitate cleaning oven surfaces, there are a number of drawbacks. First, the latex material contains certain undesirable constituents such as phthalates. In addition, the curing time is longer than desired and can be as much as 4-5 hours. The latex material is brush or roller applied and as such, may be messy or difficult to apply and may not apply evenly on the oven surfaces. In certain cases, the latex material, which has a temperature limitation of about 100°C, may not be sufficiently high for reflow oven operations.

Accordingly there is a need for a liner, system and method for reflow oven contamination control and cleaning. Desirably, such a system is easy to use and/or apply, remove and reapply. More desirably, such a system and method functions well over a wider variety of operating temperatures and over temperatures that cover the operating temperatures of ovens in the reflow process. More desirably still, such a system and method allow for application using standard or known tools.

### SUMMARY

A liner for contamination control in a reflow oven and a method of treating the surface of a reflow oven according to the present invention are defined in claims 1 and 7 respectively.

A
liner for contamination control in a reflow oven is easy to use and/or apply, remove and reapply. A typical reflow oven includes surfaces, such as side walls, a bottom wall and a top wall. The liner and system include a substrate having a length and a width that define an area. The substrate has a thickness defined by first and second sides.

An adhesive is positioned or applied on the first side of the substrate. The substrate is removably adhered to the surfaces of the reflow oven and is configured to accumulate solder reflow contaminants thereon and is further configured for removal from the surfaces with the accumulated contaminants.

The adhesive can be present as one or more strips positioned longitudinally along a length of the strip of material. The adhesive can be positioned longitudinally along the strip parallel to longitudinal axis of the strip of material. In an embodiment, three strips of adhesive are positioned along the strip of material, two of the adhesive strips positioned at about outer edges of the strip and a third adhesive strip positioned therebetween.

In an embodiment, the substrate is formed from a heat tolerant material compatible with reflow oven temperatures up to and including about 220°C and the adhesive is formed from a heat tolerant material compatible with reflow oven temperatures up to and including about 220°C. The adhesive is non-curing up to the reflow oven temperature of about 220°C, such that the adhesive does not set-up or cure and is readily removable from the oven surfaces after heat-up and cool down. In an embodiment, the strip (i.e., the adhesive) is removable from the surfaces at a temperature of less than about 50°C. According to the present invention, the adhesive covers less than an entirety of the first side.

The liner includes according to the present invention a contaminant absorbing material positioned on the second side of the substrate. The contaminant absorbing material is formed from a heat tolerant material compatible with reflow oven temperatures up to and including about 220°C.

According to the present invention, the method of treating the surfaces of a reflow oven for contamination control includes applying a substrate having a length and a width that define an area and a thickness defined by first and second sides one or more surfaces of the reflow oven. In an embodiment, the substrate is formed from a heat tolerant material compatible with reflow oven temperatures up to and including about 220°C.

The substrate is adhered to the one or more surfaces using a heat tolerant adhesive compatible with reflow oven temperatures up to and including about 220°C. The substrate is removably adhered to the surfaces of the reflow oven and the liner is configured to accumulate solder reflow contaminants thereon and configured for removal from the surfaces with the accumulated contaminants.

In accordance with the present invention, the substrate is applied in strips. Multiple strips of substrate are applied to the surfaces. In an embodiment, the edges of the strips overlap edges of adjacent strips. In an alternate embodiment, the strips abut one another and do not overlap.

In an embodiment, the adhesive is discontinuously applied to the substrate. The adhesive is, according to the present invention, applied to less than an entirety of the first side of the substrate. The method includes according to the present invention a substrate having a contaminant absorbing material on a second side, opposite of the adhesive.

These and other features and advantages of the present invention will be apparent from the following detailed description, in conjunction with the appended claims.

### BRIEF DESCRIPTION OF THE DRAWINGS

FIG. 1 is a perspective view of an example of a surface mounted technology (SMT) production line illustrating, among the components, a reflow oven in which a reflow oven liner and method may be used;
FIG. 2 is a schematic view of an example of a reflow oven;
FIG. 3 is a perspective view of a reflow oven chamber;
FIG. 4 is a schematic cross-sectional view of an interior of the reflow oven chamber;
FIG. 5 is a schematic top view illustrating one embodiment of a liner of the present disclosure;
FIG. 6 is a cross-sectional illustration of the liner of FIG. 5 taken along line 6--6 of FIG. 5;
FIG. 7 is a bottom view of the liner of FIG. 5;
FIGS. 8A and 8B illustrate two examples of liners as they are applied in an oven; and
FIG. 9 illustrates a roll form, which is one way in which the liners can be packaged for handling and use.

### DETAILED DESCRIPTION

While the present device is susceptible of embodiment in various forms, there is shown in the figures and will hereinafter be described a presently preferred embodiment with the understanding that the present disclosure is to be considered an exemplification of the device and is not intended to be limited to the specific embodiment illustrated.

Solder paste is routinely used in the assembly of printed circuit boards, where the solder paste is used to join electronic components to the circuit board. Solder paste includes solder for joint formation and flux for preparing metal surfaces for solder attachment. The solder paste may be deposited onto the metal surfaces (e.g., electronic pads) provided on the circuit board by using any number of application methods. Leads of an electronic component are aligned with and impressed into solder deposited on the pads to form the assembly. In a reflow soldering processes, the solder is then heated to a temperature sufficient to melt the solder and cooled to permanently couple the electronic component, both electrically and mechanically, to the circuit board. The solder typically includes an alloy having a melting temperature lower than that of the metal surfaces to be joined. The temperature must be sufficiently low so as to not cause damage to the electronic component. In certain embodiments, the solder may be a tin-lead alloy. However, solders employing lead-free materials may also be used.

In the solder, the flux typically includes a vehicle, solvent, activators and other additives. The vehicle is a solid or nonvolatile liquid that coats the surface to be soldered and can include rosin, resins, glycols, polyglycols, polyglycol surfactants, and glycerin. The solvent, which evaporates during the pre-heat and soldering process, serves to dissolve the vehicle activators, and other additives. Examples of typical solvents include alcohols, glycols, glycol esters and/or glycol ethers and water. The activator enhances the removal of metal oxide from the surfaces to be soldered. Common activators include amine hydrochlorides, dicarboxylic acids, such as adipic or succinic acid, and organic acids, such as citric, malic or abietic acid. Other flux additives can include surfactants, viscosity modifiers and additives for providing low slump or good tack characteristics for holding the components in place before reflow.

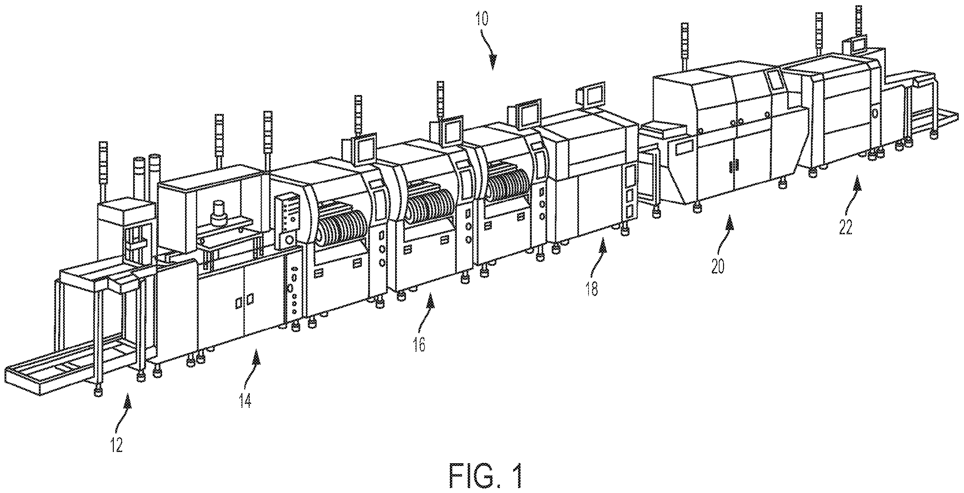

One example of a surface mounted technology process line, illustrated generally at 10, is shown in FIG. 1. The example process line 10 includes a printed circuit board (PCB) loader 12, a screen printer 14 to apply, deposit or print the solder onto the PCB, a pick and place station 16 at which components are placed onto the PCB, and a visual inspection station 18 to assure proper placement of the components.

The process line 10 includes a reflow oven 20 in which the solder is heated to melting to electronically connect and mechanically secure the components to the PCB. The assembled PCB is subsequently cooled, tested in an in-circuit tester 22 and an unloaded at an unloading station 24. Those skilled in the art will recognize and appreciate the SMT process line as well as the possible variations on and from the example line illustrated and described.

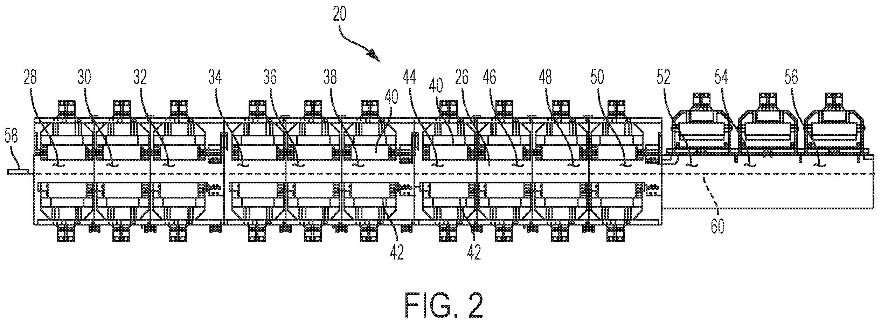

One example of a reflow oven 20 is shown in FIG. 2 and includes, generally, a reflow oven chamber 26 in the form of a thermally insulated tunnel defining a passage for pre-heating, reflowing and then cooling solder on a circuit board passing through the chamber. The reflow oven chamber 26 extends across a plurality of heating zones, including, in one example, three pre-heat zones 28, 30, 32 followed by three soak zones 34, 36, 38, each soak zone having top and bottom heaters 40, 42, respectively. The soak zones 34, 36, 38 are followed by four spike zones 44, 46, 48, 50, for example, which likewise include heaters 40, 42. And finally, three cooling zones 52, 54, 56 follow the spike zones 44, 46, 48, 50.

A circuit board assembly 58, including deposited solder paste and electronic components, is conveyed left-to-right in FIGS. 1 and 2, and in the reflow oven 20, through each zone of the chamber 26 on a conveyor 60. This provides for controlled and gradual pre-heat, reflow and post-reflow cooling of the circuit board assembly. In the preliminary pre-heat zones 28, 20, 32, the board is heated from ambient temperature up to the flux activation temperature, which may range between about 130°C and about 150°C for lead-based solders and higher for lead-free solders.

In the soak zones 34, 36 38, variations in temperature across the circuit board assembly are stabilized and time is provided for the activated flux to clean the component leads, electronic pads and solder powder before reflow. Additionally, volatile organic compounds (VOCs) in the flux are vaporized. The temperature in the soak zones 34, 36, 38 is typically about 140°C to about 160°C for lead-based solders and higher for lead-free solders. In certain embodiments, the circuit board assembly may spend about thirty to about forty-five seconds passing through the soak zones 34, 36, 38.

In the spike zones 44, 46, 48, 50, the temperature quickly increases to a temperature above the melting point of the solder to reflow the solder. The melting point for eutectic or near-eutectic tin-lead solder is about 183°C, with the reflow spike being typically set about 25°C to about 50°C above the melting point to overcome a pasty range of molten solder. For lead-based solders, a typical maximum temperature in the spike zones is in the range of about 200°C to about 220°C. Temperatures above about 225°C may cause baking of the flux, damage to the components and/or sacrifice joint integrity. Temperatures below about 200°C may prevent the joints from fully reflowing. In an embodiment, the circuit board assembly is typically maintained at a temperature within the spike zones 44, 46, 48, 50 above the reflow temperature for about one minute.

In the cooling zones 52, 54, 56, the temperature drops below the reflow temperature, and the circuit board assembly is cooled sufficiently to solidify the joints and thereby preserve joint integrity before the circuit board assembly leaves the reflow oven chamber 12. A flux extraction/filtration system (not shown) may be provided to remove contaminant materials from the gas generated by the reflow soldering oven 20.

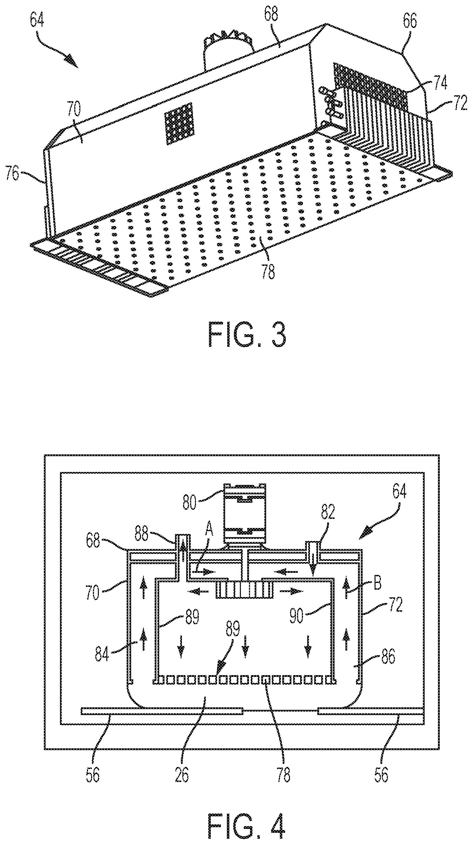

Turning now to FIGS. 3 and 4, the several zones (e.g., pre-heat zones 28, 30, 32, soak zones 34, 36, 38, and/or spike zones 44, 46, 48, 50) including heaters 40, 42 of the reflow oven include a reflow oven chamber assembly, which is generally indicated at 64. In the illustrated embodiment, the reflow oven chamber assembly 64 may include one or more zones. It should be noted that the reflow oven chamber assembly 64 may be configured to have any suitable number of zones needed or required within the reflow soldering oven. Also, it should be noted that FIG. 4 illustrates the upper reflow oven chamber assembly 64. A similar lower reflow oven chamber assembly may be provided in addition to or in lieu of the upper reflow oven chamber assembly to deliver heated air from below the printed circuit board as the board travels through the reflow oven.

Referring to FIG. 4, the reflow oven chamber assembly 64 includes, in an embodiment, a rectangular-shaped chamber housing, indicated at 66, having a top 68, two relatively longer sides 70, 72, two relatively shorter ends 74, 76, and a bottom, which functions as a diffuser plate 78. In one embodiment, the chamber housing 66 is fabricated from stainless steel. An air blower device 80 is provided on the top 68 of the chamber housing 66 to direct air from an inlet 82 provided in the top 68 of the chamber housing 66 to the reflow oven chamber 26. Air is exhausted out of plenums 84, 86 provided along respective sides 70, 72 of the chamber housing 66 toward an outlet 88, which is also provided in the top 68 of the chamber housing 66. The chamber housing 66 is configured to enclose and mount the components of the reflow oven chamber assembly 64, and to be suitably secured within the reflow oven chamber 26 of the reflow soldering oven 20.

The diffuser plate 78 distributes air from the reflow oven chamber assembly 64 to the reflow oven chamber 26. The diffuser plate 78 can include holes in a pattern, such as the illustrated staggered pattern, to provide consistent, uniform airflow to the printed circuit board 58. These holes can be stamped from sheet metal material such that they form a converging nozzle that results in a uniform airstream. The arrangement is such that air flows through the reflow oven chamber assembly 64 generated by the air blower device 80 with air entering the inlet 82 and exiting the diffuser plate 78. Air can enter the inlet 82 as illustrated by arrows A and exit through the outlet 88 as illustrated by arrows B through the plenums 84, 86.

Referring now to FIGS. 4-7, in order to address flux deposition on the bottom or floor and inner walls of the heating/cooling chambers, the surfaces 89 of the chamber housing 66, including the diffuser plate 78 and the plenums 84, 86, may be treated with a layer of removable material, indicated generally at 90, to enable the easy removal of flux and other contaminants that build up over time on these surfaces 89. According to the present invention, the material includes a reflow oven liner system 92 having a base material or substrate 94 and an adhesive 96 to removably secure the substrate 94 to the chamber surfaces 89. The substrate 94 has certain characteristics that permit its use in the reflow oven 20 environment, that is, at temperatures up to and including about 220°C. Suitable substrate 94 materials include foils, temperature tolerant non-metals, such as cotton-based or glass fibers in the form of films, and the like.

The adhesive 96 is present on a side 98 of the substrate 94 to temporarily secure the substrate 94 to the chamber surfaces 89. The adhesive 96, similar to the substrate 94, is a heat tolerant material that must retain its adhesive characteristics at elevated temperatures and not cure or harden as a result of being held at such temperatures. The adhesive 96 is according to the present invention of the type that can be readily removed from the chamber surfaces 89 after being subjected to elevated temperatures and be removable from the surfaces 89, with the substrate 94, at about ambient temperatures or slightly elevated temperatures, for example at or about 50°C.

According to the present invention, the substrate 94 is in the form of flexible strips 100 of material and the adhesive 96 is disposed, at least in part, along portions of edges 102 of the substrate 94. This effectively permits applying the liner system 92 to the surfaces 89 in strips 100 that are readily applied and removed when replacement is desired. In an embodiment, the strips 100 are formed in widths w₁₀₀ of about 50.8 to about 76.2 mm (about 2 to about 3 inches).

According to the present invention, the liner strips 100 include an absorbent 104 or other material to help contain the contaminants. The flux absorbent material 104 is positioned on a side 106 of the substrate 94 opposite the adhesive 96 so that the absorbent 104 is facing inward of the chamber 64. The absorbent material 104 can also be applied to or positioned on the substrate 94 in a variety of patterns, such as the elongated strip 100 pattern shown. Other patterns and areas of coverage will be appreciated by those skilled in the art and are within the scope and spirit of the present disclosure.

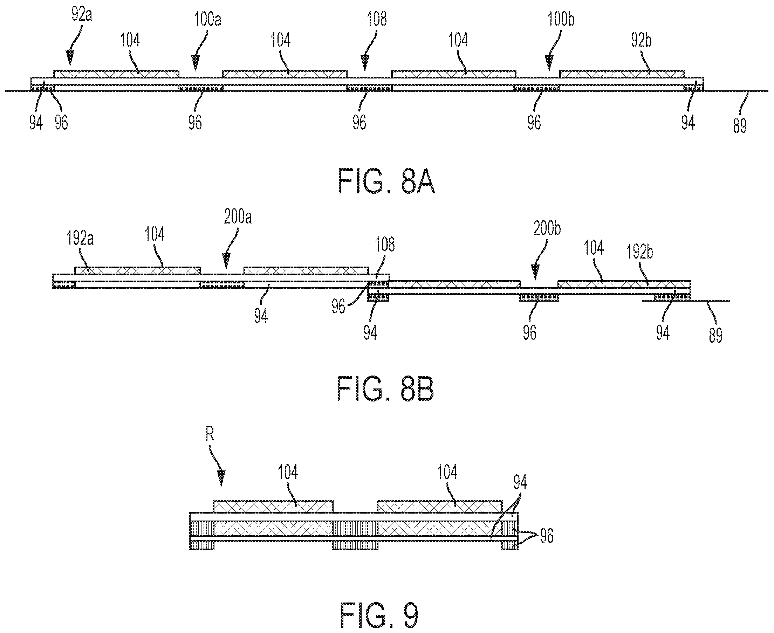

In an embodiment the adhesive 96 is present as three parallel strips 96a,b,c running longitudinally along the substrate 94, parallel to a centerline C₉₄ of the substrate 94. The absorbent material 104 is present as two parallel strips 104a,b running longitudinally along the substrate 94, parallel to a centerline C₉₄ of the substrate 94 on the side 106 of the substrate 94 opposite the adhesive 96. In such an arrangement, the adhesive 96 can be, for example, a self-stick adhesive having a release layer, a water activated adhesive, a tacky adhesive that permits overlapping layers of the strips 100 onto one another (to, for example, store the liner strips in roll form), or any other suitable arrangement, configuration and/or formulation. In one embodiment, the liner 92 is supplied on rolls R, a cross-section of which is as illustrated in FIG. 9. It is anticipated that a roll-form R of the liner system 92 can be provided and used in cooperation with a tape applicator, such as a commonly known tape gun, to facilitate application to the chamber surfaces. In the illustrated cross-section of the roll R in FIG. 9, it will be appreciated that in the roll R form, the absorbent material 104 of a lower layer in the roll will reside between the adhesive strips 96 of an upper layer so as to provide a compact and easily usable liner system roll R.

In application, the liner 92 can be positioned or applied in, for example, a side-by-side application, as illustrated in FIG. 8A, in which the edges 102 of adjacent liners 92a,b are abutting one another, or in an overlapping manner, as illustrated in FIG. 8B in which edge regions 108 of adjacent liners 192a, 192b overlap to ensure complete coverage of the surfaces 89. It will be appreciated that although the illustration of FIG. 8B shows that the liner 192a is elevated above the surface 89, that the liner 192a is flexible and will conform, curve or bend at the juncture of the liners 192a and 192b so that liner 192a will lie flat on the surface 89other than immediately at the juncture.

A method of treating the surfaces 89 of a reflow oven for contamination control includes applying a substrate 94 having a length and a width that define an area and a thickness t₉₄ defined by first 98 and second 106 sides onto one or more surfaces 89 of the reflow oven 20. In an embodiment, the substrate 94 is formed from a heat tolerant material compatible with reflow oven 20 temperatures up to and including about 220°C.

The substrate 94 is adhered to the one or more surfaces 89 using a heat tolerant adhesive 96 also compatible with reflow oven 20 temperatures up to and including about 220°C. The substrate 94 is removably adhered to the surfaces 89 of the reflow oven 20 and the liner 92 is configured to accumulate solder reflow contaminants thereon and configured for removal from the surfaces 89 with the accumulated contaminants. The liner 92 can be readily removed by hand or with commonly available tools. It is anticipated that the liner 92 will remove easily (e.g., in one piece) with only nominal effort.

According to the present invention, the liner 92 is applied in strips 100. Multiple strips 100a,b of the liner system 92 are applied to the surfaces 89. In an embodiment, the edge regions 108 of the a strip 100a overlaps edges 108 of an adjacent strip 100b (see, e.g., FIG. 8B). In an alternate embodiment, the strips 100 abut one another and do not overlap (see, e.g., FIG. 8A).

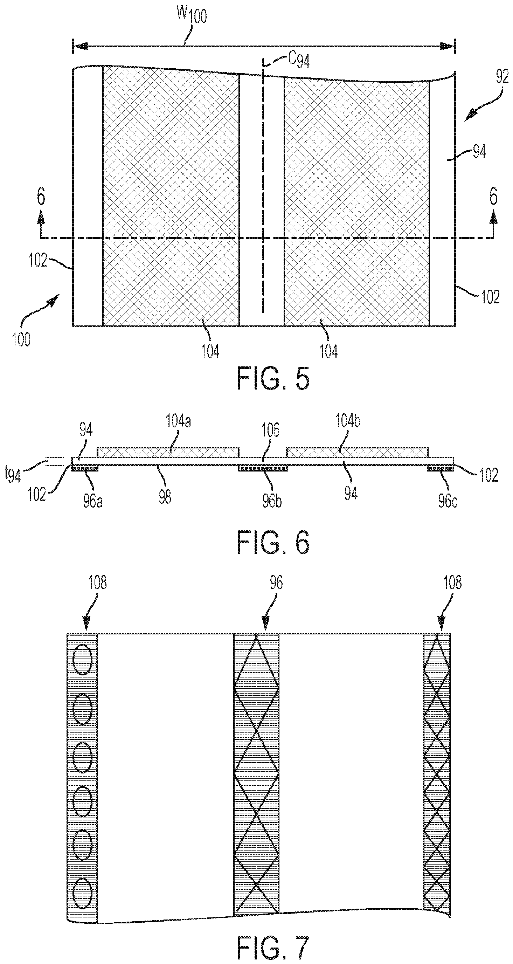

In an embodiment, the adhesive 96 is discontinuously applied to the substrate 94. The adhesive 96 is applied according to the present invention to less than an entirety of the first side 98 of the substrate 94, for example in stripe (as seen in e.g., FIG. 7), in dots, in a sinuous pattern, and the like. According to the present invention, a substrate 94 has a contaminant absorbing material 104 on a side 106 opposite of the adhesive 96. That is, the method includes according to the present invention providing a contaminant absorbing material 104 on a side 106 of the substrate 94.

It will be understood that the adhesive 96 is one that does not cure or become permanently adhered to the chamber surfaces 89. Rather, the adhesive 96 should be selected so that even with repeated heat-up and cool-down cycles, the adhesive 96 will retain such characteristics that allow it to be readily removed from the chamber surfaces 89 with nominal or minimal effort.

It will also be appreciated that the present liner and method of reflow oven contamination control and cleaning provide a system that is easy to use and/or apply, remove and reapply. The present liner, system and method function well over a wide variety of operating temperatures and over temperatures that cover the operating temperatures of reflow ovens in the reflow process and allow for application using standard or known tools and methods.

It will be appreciated by those skilled in the art that the relative directional terms such as upper, lower, rearward, forward and the like are for explanatory purposes only and are not intended to limit the scope of the disclosure.

In the present disclosure, the words "a" or "an" are to be taken to include both the singular and the plural. Conversely, any reference to plural items shall, where appropriate, include the singular.

From the foregoing it will be observed that numerous modifications and variations can be effectuated without departing from the scope of the novel concepts of the present disclosure. It is to be understood that no limitation with respect to the specific embodiments illustrated is intended or should be inferred. The disclosure is intended to cover all such modifications as fall within the scope of the claims.

## Claims

1. A liner (92, 192) for contamination control in a reflow oven (20), the reflow oven (20) having surfaces (89), comprising:
- a substrate (94) having a length and a width defining an area, the substrate (94) having a thickness, the substrate (94) having first and second sides (98, 106); and
- an adhesive (96) positioned on the first side (98) of the substrate (94), wherein the substrate (94) is removably adhered to the surfaces (89) of the reflow oven (20) and configured for removal from the surfaces (89) of the reflow oven (20),
wherein the substrate (94) comprises a contaminant absorbing material (104) configured to accumulate solder reflow contaminants thereon,
**characterized in that**
the liner (92, 192) is in the form of multiple strips (100) of material removably adhered to the surfaces (89),
wherein the adhesive (96) is of the type that can be readily removed from the chamber surfaces (89) after being subjected to elevated temperatures and be removable from the surfaces (89), with the substrate (94), at about ambient temperatures or slightly elevated temperatures, and is positioned longitudinally along the strips (100) of material parallel to longitudinal axis of the strips of material (104), and
wherein the adhesive (96) covers less than an entirety of the first side (98).

2. The liner (92, 192) of claim 1,
wherein the adhesive (96) is present as strip positioned longitudinally along a length of the strip (100) of material.

3. The liner (92, 192) of claim 1,
wherein three strips of adhesive (96) are positioned along the strip (100) of material, wherein two of the strips of adhesive (96) are positioned at about outer edges (108) of the strip (100) and a third strip of adhesive (96) is positioned therebetween.

4. The liner (92, 192) of one of the preceding claims,
wherein the substrate (94) is formed from a heat tolerant material compatible with reflow oven temperatures up to and including about 220°C.

5. The liner (92, 192) of claim 4,
wherein the adhesive (96) is formed from a heat tolerant material compatible with reflow oven temperatures up to and including about 220°C.

6. The liner (92, 192) of claim 5,
wherein the adhesive (96) is non-curing up to the reflow oven temperature of about 220°C, such that the adhesive (96) does not set-up or cure and is readily removable from the surfaces (89).

7. A method of treating the surfaces (89) of a reflow oven (20), the reflow oven (20) having surfaces (89), comprising:
- applying a liner (92, 192) comprising a substrate (94) having a length and a width defining an area, the substrate (94) having a thickness, the substrate (94) having first and second sides (98, 106) on a surface of the reflow oven (20), the substrate (94) being formed from a heat tolerant material compatible with reflow oven temperatures up to and including about 220°C; and
- adhering the substrate (94) to the surface (89) using a heat tolerant adhesive (96) positioned on the first side (98) of the substrate (94) and being compatible with reflow oven temperatures up to and including about 220°C,
wherein substrate (94) comprises a contaminant absorbing material (104) configured to accumulate solder reflow contaminants thereon, **characterized in that**
the liner (92, 192) is in the form of multiple strips (100) of material removably adhered to the surfaces (89),
wherein the adhesive (96) is of the type that can be readily removed from the chamber surfaces (89) after being subjected to elevated temperatures and be removable from the surfaces (89), with the substrate (94), at about ambient temperatures or slightly elevated temperatures, and is positioned longitudinally along the strips (100) of material parallel to longitudinal axis of the strips of material (104), and
wherein the adhesive (96) is applied to less than an entirety of the first side (98).

8. The method of claim 7;
wherein edges (108) of the strips (100) overlap edges of adjacent strips (100).

9. The method of one of claims 7 or 8,
wherein the contaminant absorbing material (104) is formed from a heat tolerant material compatible with reflow oven temperatures up to and including about 220°C

10. The method of one of claims 7 to 9,
wherein the adhesive (96) is discontinuously applied to the substrate (94).

## Patentansprüche

1. Auskleidung (92, 192) zur Verunreinigungssteuerung in einem Reflow-Ofen (20), wobei der Reflow-Ofen (20) Oberflächen (89) hat, Folgendes umfassend:
- ein Substrat (94) mit einer Länge und einer Breite, die eine Fläche definieren, wobei das Substrat (94) eine Dicke hat, wobei das Substrat (94) erste und zweite Seiten (98, 106) hat; und
- ein Haftmittel (96), positioniert auf der ersten Seite (98) des Substrats (94), wobei das Substrat (94) entfernbar an den Oberflächen (89) des Reflow-Ofens (20) haftet und ausgelegt ist zur Entfernung von den Oberflächen (89) des Reflow-Ofens (20),
wobei das Substrat (94) ein Verunreinigung absorbierendes Material (104) umfasst, ausgelegt zum Akkumulieren von Lötmittelrückflussverunreinigungen darauf,
**dadurch gekennzeichnet, dass**
die Auskleidung (92, 192) in der Form von mehreren Streifen (100) von Material vorliegt, die entfernbar an den Oberflächen (89) haften,
wobei das Haftmittel (96) von dem Typ ist, der problemlos von den Kammeroberflächen (89) entfernt werden kann, nachdem diese erhöhten Temperaturen ausgesetzt wurden, und von den Oberflächen (89), mit dem Substrat (94), etwa bei Umgebungstemperaturen oder geringfügig erhöhten Temperaturen entfernbar ist, und längs entlang der Streifen (100) von Material parallel zur Längsachse der Streifen von Material (104) positioniert ist, und
wobei das Haftmittel (96) weniger als eine Gesamtheit der ersten Seite (98) bedeckt.

2. Auskleidung (92, 192) nach Anspruch 1,
wobei das Haftmittel (96) als Streifen vorhanden ist, der längs entlang einer Länge des Streifens (100) von Material positioniert ist.

3. Auskleidung (92, 192) nach Anspruch 1,
wobei drei Streifen von Haftmittel (96) entlang des Streifens (100) von Material positioniert sind, wobei zwei der Streifen von Haftmittel (96) etwa an äußeren Kanten (108) des Streifens (100) positioniert sind und ein dritter Streifen von Haftmittel (96) dazwischen positioniert ist.

4. Auskleidung (92, 192) nach einem der vorhergehenden Ansprüche,
wobei das Substrat (94) aus einem wärmetoleranten Material gebildet wird, das kompatibel mit Reflow-Ofentemperaturen bis einschließlich etwa 220 °C ist.

5. Auskleidung (92, 192) nach Anspruch 4,
wobei das Haftmittel (96) aus einem wärmetoleranten Material gebildet wird, das kompatibel mit Reflow-Ofentemperaturen bis einschließlich etwa 220 °C ist.

6. Auskleidung (92, 192) nach Anspruch 5,
wobei das Haftmittel (96) bis zur Reflow-Ofentemperatur von etwa 220 °C nicht aushärtend ist, sodass das Haftmittel (96) sich nicht setzt oder aushärtet und problemlos von den Oberflächen (89) entfernbar ist.

7. Verfahren zur Behandlung von Oberflächen (89) eines Reflow-Ofens (20), wobei der Reflow-Ofen (20) Oberflächen (89) hat, Folgendes umfassend:
- Aufbringen einer Auskleidung (92, 192), umfassend ein Substrat (94) mit einer Länge und einer Breite, die eine Fläche definieren, wobei das Substrat (94) eine Dicke hat, wobei das Substrat (94) erste und zweite Seiten (98, 106) auf einer Oberfläche des Reflow-Ofens (20) hat, wobei das Substrat (94) aus einem wärmetoleranten Material gebildet ist, das kompatibel mit Reflow-Ofentemperaturen bis einschließlich etwa 220 °C ist; und
- Anheften des Substrats (94) an die Oberfläche (89) unter Verwendung eines wärmetoleranten Haftmittels (96), positioniert auf der ersten Seite (98) des Substrats (94) und kompatibel mit Reflow-Ofentemperaturen bis einschließlich etwa 220 °C, wobei das Substrat (94) ein Verunreinigung absorbierendes Material (104) umfasst, das ausgelegt ist zum Akkumulieren von Lötmittelrückflussverunreinigungen darauf,
**dadurch gekennzeichnet, dass**
die Auskleidung (92, 192) in der Form von mehreren Streifen (100) von Material vorliegt, die entfernbar an den Oberflächen (89) haften,
wobei das Haftmittel (96) von dem Typ ist, der problemlos von den Kammeroberflächen (89) entfernt werden kann, nachdem diese erhöhten Temperaturen ausgesetzt wurden, und von den Oberflächen (89), mit dem Substrat (94), etwa bei Umgebungstemperaturen oder geringfügig erhöhten Temperaturen entfernbar ist, und längs entlang der Streifen (100) von Material parallel zur Längsachse der Streifen von Material (104) positioniert ist, und
wobei das Haftmittel (96) auf weniger als eine Gesamtheit der ersten Seite (98) aufgetragen wird.

8. Verfahren nach Anspruch 7,
wobei Kanten (108) der Streifen (100) Kanten angrenzender Streifen (100) überlappen.

9. Verfahren nach einem der Ansprüche 7 oder 8,
wobei das Verunreinigung absorbierende Material (104) aus einem wärmetoleranten Material gebildet wird, das kompatibel mit Reflow-Ofentemperaturen bis einschließlich etwa 220 °C ist.

10. Verfahren nach einem der Ansprüche 7 bis 9,
wobei das Haftmittel (96) nicht zusammenhängend auf das Substrat (94) aufgetragen wird.

## Revendications

1. Revêtement (92, 192) pour contrôle de contamination dans un four à refusion (20), le four à refusion (20) ayant des surfaces (89), comprenant :
- un substrat (94) ayant une longueur et une largeur définissant une superficie, le substrat (94) ayant une épaisseur, le substrat (94) ayant des première et seconde faces (98, 106) ; et
- un adhésif (96) positionné sur la première face (98) du substrat (94), dans lequel le substrat (94) adhère de façon amovible aux surfaces (89) du four à refusion (20) et est configuré pour la dépose à partir des surfaces (89) du four à refusion (20),
dans lequel le substrat (94) comprend un matériau à absorption de contaminants (104) configuré pour accumuler des contaminants de refusion de brasure tendre sur celui-ci,
**caractérisé en ce que**
le revêtement (92, 192) est sous la forme de multiples bandes (100) de matériau adhérant de façon amovible aux surfaces (89),
dans lequel l'adhésif (96) est du type qui peut être facilement déposé à partir des surfaces de chambre (89) après avoir été soumis à des températures élevées et être amovible à partir des surfaces (89), avec le substrat (94), à des températures environ ambiantes ou des températures légèrement élevées, et est positionné longitudinalement le long des bandes (100) de matériau parallèlement à un axe longitudinal des bandes de matériau (104), et
dans lequel l'adhésif (96) couvre moins d'une totalité de la première face (98).

2. Revêtement (92, 192) selon la revendication 1,
dans lequel l'adhésif (96) est présent sous forme de bande positionnée longitudinalement le long d'une longueur de la bande (100) de matériau.

3. Revêtement (92, 192) selon la revendication 1,
dans lequel trois bandes d'adhésif (96) sont positionnées le long de la bande (100) de matériau, dans lequel deux des bandes d'adhésif (96) sont positionnées au niveau de bords environ extérieurs (108) de la bande (100) et une troisième bande d'adhésif (96) est positionnée entre ceux-ci.

4. Revêtement (92, 192) selon l'une des revendications précédentes,
dans lequel le substrat (94) est formé à partir d'un matériau tolérant la chaleur, compatible avec des températures de four à refusion allant jusqu'à, et y compris, environ 220°C.

5. Revêtement (92, 192) selon la revendication 4,
dans lequel l'adhésif (96) est formé à partir d'un matériau tolérant la chaleur, compatible avec des températures de four à refusion allant jusqu'à, et y compris, environ 220°C.

6. Revêtement (92, 192) selon la revendication 5,
dans lequel l'adhésif (96) est non durcissant jusqu'à la température de four à refusion d'environ 220°C, de telle sorte que l'adhésif (96) ne sèche pas ou ne durcisse pas et soit facilement amovible à partir des surfaces (89).

7. Procédé de traitement des surfaces (89) d'un four à refusion (20), le four à refusion (20) ayant des surfaces (89), comprenant :
- l'application d'un revêtement (92, 192) comprenant un substrat (94) ayant une longueur et une largeur définissant une superficie, le substrat (94) ayant une épaisseur, le substrat (94) ayant des première et seconde faces (98, 106) sur une surface du four à refusion (20), le substrat (94) étant formé à partir d'un matériau tolérant la chaleur, compatible avec des températures de four à refusion allant jusqu'à, et y compris, environ 220°C ; et
- l'adhérence du substrat (94) à la surface (89) en utilisant un adhésif tolérant la chaleur (96) positionné sur la première face (98) du substrat (94) et compatible avec des températures de four à refusion allant jusqu'à, et y compris, environ 220°C,
dans lequel le substrat (94) comprend un matériau à absorption de contaminants (104) configuré pour accumuler des contaminants de refusion de brasure tendre sur celui-ci,
**caractérisé en ce que**
le revêtement (92, 192) est sous la forme de multiples bandes (100) de matériau adhérant de façon amovible aux surfaces (89),
dans lequel l'adhésif (96) du type qui peut être facilement déposé à partir des surfaces de chambre (89) après avoir été soumis à des températures élevées et être amovible à partir des surfaces (89), avec le substrat (94), à des températures environ ambiantes ou des températures légèrement élevées, et est positionné longitudinalement le long des bandes (100) de matériau parallèlement à axe longitudinal des bandes de matériau (104), et
dans lequel l'adhésif (96) est appliqué sur moins d'une totalité de la première face (98).

8. Procédé selon la revendication 7,
dans lequel des bords (108) des bandes (100) chevauchent des bords de bandes adjacentes (100).

9. Procédé selon l'une des revendications 7 ou 8,
dans lequel le matériau à absorption de contaminants (104) est formé à partir d'un matériau tolérant la chaleur, compatible avec des températures de four à refusion allant jusqu'à, et y compris, environ 220°C.

10. Procédé selon l'une des revendications 7 à 9,
dans lequel l'adhésif (96) est appliqué de façon discontinue sur le substrat (94).
